# EUROPEAN PATENT APPLICATION

(11) **EP 4 648 099 A1**
(43) Date of publication of application: **12.11.2025**
(21) Application number: 25166114.6
(22) Date of filing: 25.03.2025
(51) Int. Cl.: H01L 23/373, H01L 23/31, H01L 23/433

(54) **POWER MODULE AND POWER CONVERTER**

(30) Priority: 08.05.2024 CN 202410560779
(71) Applicant: Huawei Digital Power Technologies Co., Ltd., Shenzhen, Guangdong 518043 (CN)
(72) Inventor: LIU, Zhiling, Shenzhen, 518043 (CN); XU, Di, Shenzhen, 518043 (CN); ZHOU, Jiakan, Shenzhen, 518043 (CN)
(74) Representative: Isarpatent

(57) **Abstract**

A power module and a power converter are provided. The power module includes a thermally conductive base plate, a connection layer, a ceramic substrate, and a chip that are sequentially stacked. A molding body wraps the ceramic substrate and the chip. The ceramic substrate includes an insulation layer and a first metal layer. The first metal layer is disposed between the insulation layer and the connection layer. A reinforcing structure is formed on a side that is of the thermally conductive base plate and that faces the ceramic substrate. The reinforcing structure is located on a side portion of the connection layer in a direction perpendicular to an arrangement direction of the thermally conductive base plate and the connection layer. A wall surface of the reinforcing structure and a surface that is of the first metal layer and that faces the thermally conductive base plate enclose a containing space. The molding body fills the containing space. The molding body in the containing space wraps the surface that is of the first metal layer and that faces the thermally conductive base plate and a joint between a side surface of the first metal layer and the insulation layer, and transfers a stress concentration position on the ceramic substrate from the joint between the side surface of the first metal layer and the insulation layer to the surface that is of the first metal layer and that faces the thermally conductive base plate. This reduces a risk of layering or cracking of the insulation layer and helps improve reliability of the power module.

## Description

### TECHNICAL FIELD

This application relates to the field of semiconductor packaging technologies, and in particular, to a power module and a power converter.

### BACKGROUND

In the field of new energy like photovoltaics and automobiles, power modules are important modules in power electronic systems of the field of new energy, and are widely used in servo motors, inverters and other components. The power module is a package structure that integrates a plurality of parts and components such as a power chip and a ceramic substrate. Usually, heat generated when the power chip works is mainly dissipated externally by using the ceramic substrate and a thermally conductive base plate (BP). Use of a high thermally conductive ceramic substrate can significantly improve a heat dissipation capability of the power module. However, for a high thermally conductive ceramic material, force strength of the ceramic material is usually low, and a risk of layering or cracking is high. This cannot meet a long-term reliability requirement of the power module.

### SUMMARY

A technical problem to be resolved in embodiments of this application is to provide a power module with high reliability and a power converter.

According to a first aspect, embodiments of this application provide a power module, including a thermally conductive base plate, a ceramic substrate, a chip, a molding body, and a connection layer. The thermally conductive base plate, the connection layer, the ceramic substrate, and the chip are sequentially stacked. The molding body wraps the ceramic substrate and the chip. The ceramic substrate includes an insulation layer and a first metal layer. The first metal layer is disposed between the insulation layer and the connection layer. A reinforcing structure is formed on a side that is of the thermally conductive base plate and that faces the ceramic substrate. The reinforcing structure is located on a side portion of the connection layer in a direction perpendicular to a stacking direction of the thermally conductive base plate and the connection layer. A wall surface of the reinforcing structure and a surface that is of the first metal layer and that faces the thermally conductive base plate enclose a containing space. The molding body fills the containing space.

For a power module packaged in a molding form, a molding compound imposes a large squeezing force on a side surface of a ceramic substrate. The ceramic substrate includes a ceramic insulation layer and a lower copper layer. In addition, an outer edge of the ceramic insulation layer usually protrudes relative to an outer edge of the lower copper layer. A shape of a joint between a side surface of the lower copper layer and the ceramic insulation layer changes sharply. This is prone to a stress concentration problem. The ceramic insulation layer has low force strength, and is prone to a risk of layering or cracking. This cannot meet a long-term reliability requirement of the power module.

The reinforcing structure is formed on the thermally conductive base plate, the reinforcing structure is located on the side that is of the thermally conductive base plate and that faces the ceramic substrate, and the reinforcing structure and the first metal layer enclose the containing space, so that the molding body can be filled between the thermally conductive base plate and the first metal layer. The molding body provides a support force for the surface that is of the first metal layer and that faces the thermally conductive base plate. In addition, the molding body wraps the surface that is of the first metal layer and that faces the thermally conductive base plate and a joint between a side surface of the first metal layer and the insulation layer, and transfers a stress concentration position on the ceramic substrate from the joint between the side surface of the first metal layer and the insulation layer to the surface that is of the first metal layer and that faces the thermally conductive base plate. This effectively reduces a case in which the molding body squeezes only the joint between the side surface of the first metal layer and the insulation layer, optimizes stress distribution inside the power module, reduces a risk of layering or cracking of the insulation layer, and helps improve long-term reliability of the power module. In addition, the reinforcing structure is disposed on the side portion of the connection layer, so that the molding body filled between the thermally conductive base plate and the first metal layer is disposed around the connection layer, and the molding body can wrap, as much as possible, a side surface of the ceramic substrate and a surface that is of the ceramic substrate and that faces the thermally conductive base plate, thereby further reducing a risk of layering or cracking of the insulation layer.

In a possible implementation, there are a plurality of reinforcing structures, and the plurality of reinforcing structures are disposed around the connection layer and spaced apart.

In this possible implementation, the reinforcing structures are spaced apart around an outer circumference of the connection layer, and the molding body can wrap, as much as possible, the side surface of the ceramic substrate and the surface that is of the ceramic substrate and that faces the thermally conductive base plate, thereby further reducing a risk of layering or cracking of the insulation layer.

In a possible implementation, the first metal layer has a plurality of corners, and each corner corresponds to one reinforcing structure. One end of the reinforcing structure extends toward one edge of the corner, and the other end of the reinforcing structure extends toward the other adjacent edge of the corner.

In this possible implementation, a shape of the corner of the first metal layer changes sharply. This is prone to a stress concentration problem and a risk of cracking of the insulation layer at a corresponding position. At the corner of the first metal layer, the reinforcing structure extending to two adjacent edges of the corner is disposed, so that the molding body filled between the thermally conductive base plate and the first metal layer can extend to the two adjacent edges of the corner, a risk of layering or cracking of the insulation layer at the corner is reduced, and reliability of the power module is improved.

In a possible implementation, the reinforcing structure includes a groove. The groove is filled with the molding body.

In this possible implementation, the groove is formed on the thermally conductive base plate, and wall surfaces of the groove and the surface that is of the first metal layer and that faces the thermally conductive base plate jointly enclose the containing space. A structure is simple and easy to implement. In addition, arrangement of the groove enables the molding body filled between the thermally conductive base plate and the first metal layer to extend to an outer circumference of the connection layer, so that a contact area between the molding body and the surface that is of the first metal layer that faces the thermally conductive base plate is maximized. This increases a contact area between the molding body and the first metal layer, optimizes stress distribution inside the power module, reduces a risk of layering or cracking of the insulation layer, and improves reliability of the power module.

In a possible implementation, an edge that is of an orthographic projection of the groove and that is away from the connection layer is located outside an outer edge of an orthographic projection of the first metal layer in an arrangement direction of the thermally conductive base plate and the ceramic substrate.

In this possible implementation, a side that is of the groove and that is away from the connection layer extends beyond an outer edge of the first metal layer. In this way, an edge of the side that is of the groove and that is away from the connection layer is staggered with a side edge of the first metal layer, a position at which a shape of the side surface of the ceramic substrate changes sharply is staggered with a position at which the molding body changes sharply, the contact area between the molding body and the first metal layer is increased, stress distribution inside the power module is optimized, a risk of layering or cracking of the insulation layer is reduced, and reliability of the power module is improved.

In a possible implementation, at least a part of an orthographic projection of the groove is located within an outer edge of an orthographic projection of the first metal layer in an arrangement direction of the thermally conductive base plate and the ceramic substrate.

In this possible implementation, the molding body can be filled between the thermally conductive base plate and the first metal layer and at least partially located within an outer edge of the first metal layer, so that a stress concentration position on the ceramic substrate is transferred to the surface that is of the first metal layer and that faces the thermally conductive base plate. This reduces a risk of layering or cracking of the insulation layer and helps improve reliability of the power module.

In a possible implementation, the reinforcing structure includes a boss. The boss protrudes toward the first metal layer. The boss is located on the side portion of the connection layer. A surface that is of the boss and that faces away from the connection layer, a surface that is of the thermally conductive base plate and that faces the first metal layer, and the surface that is of the first metal layer and that faces the thermally conductive base plate enclose the containing space. An orthographic projection of the boss is located within an outer edge of an orthographic projection of the first metal layer in an arrangement direction of the thermally conductive base plate and the ceramic substrate.

In this possible implementation, there is a spacing between the first metal layer and a part that is of the thermally conductive base plate and on which no boss is disposed, so that the surface that is of the boss and that faces away from the connection layer, the surface that is of the thermally conductive base plate and that faces the first metal layer, and the surface that is of the first metal layer and that faces the thermally conductive base plate enclose the containing space. The molding body can extend to a side that is of the first metal layer and that faces the thermally conductive base plate, so that a stress concentration position on the ceramic substrate is transferred to the surface that is of the first metal layer and that faces the thermally conductive base plate. This reduces a risk of layering or cracking of the insulation layer and helps improve reliability of the power module. In addition, the boss is located on the side portion of the connection layer, and the boss may limit the connection layer, to effectively reduce a possibility that the connection layer extends to the side surface of the first metal layer.

In a possible implementation, the reinforcing structure includes a boss and a groove. Both the boss and the groove are located on the side portion of the connection layer, and the boss is located between the connection layer and the groove. An orthographic projection of the boss is located within an outer edge of an orthographic projection of the first metal layer in an arrangement direction of the thermally conductive base plate and the ceramic substrate. The groove is filled with the molding body.

In this possible implementation, the boss and the groove are sequentially disposed on the side portion of the connection layer. A surface that is of the boss and that faces away from the connection layer, the surface that is of the first metal layer and that faces the thermally conductive base plate, and wall surfaces of the groove jointly enclose the containing space. The boss may limit the connection layer. In addition, arrangement of the groove further increases a depth of the containing space. In this way, the molding body is filled more on a side that is of the first metal layer and that faces the thermally conductive base plate. This enhances support for the ceramic substrate, reduces a risk of layering or cracking of the ceramic substrate, and helps improve reliability of the power module.

In a possible implementation, a surface that is of the boss and that faces the first metal layer is attached to the first metal layer.

In an implementation in which the reinforcing structure includes a boss, the boss can support the first metal layer, and flow in a soldering process of the connection layer to a side that is of the boss and that faces away from the connection layer is effectively reduced, to effectively limit the connection layer.

In a possible implementation, the groove includes a bottom wall, a first side wall, and a second side wall. The first side wall is connected to an edge of a side that is of the bottom wall and that faces the connection layer, and the second side wall is connected to an edge of a side that is of the bottom wall and that faces away from the connection layer. The first side wall is inclined relative to a joint between the first side wall and the bottom wall toward of the second side wall; and/or the second side wall is inclined relative to a joint between the second side wall and the bottom wall away from the first side wall.

In an implementation in which the reinforcing structure includes a groove, a first side wall and a second side wall are disposed on edges of two opposite sides of a bottom wall, and the first side wall is inclined relative to a joint between the first side wall and the bottom wall toward the second side wall. Even if the molding body and the thermally conductive base plate have risks of layering or cracking, positions of layering or cracking may be concentrated at the joint between the first side wall and the bottom wall, and is not easily extended to the connection layer to cause layering or cracking of the connection layer. This helps improve reliability of connections between the thermally conductive base plate and the connection layer, and between the first metal layer and the connection layer. When the second side wall is inclined relative to a joint between the second side wall and the bottom wall away from the first side wall, transition of an edge of a side that is of the groove and that is away from the connection layer is gentle. This helps reduce stress of the molding body on the side that is of the groove and that is away from the connection layer, and reduce a risk of cracking of the molding body.

According to a second aspect, this application provides a power converter, including a circuit board and the power module according to the first aspect. The power module is disposed on the circuit board.

### BRIEF DESCRIPTION OF DRAWINGS

To describe technical solutions in embodiments of this application or in the background more clearly, the following describes the accompanying drawings for describing embodiments of this application or the background.
FIG. 1 is a diagram of a structure of a vehicle according to an embodiment of this application;
FIG. 2 is a diagram of networking of a photovoltaic energy storage system according to an embodiment of this application;
FIG. 3 is a diagram of a structure of a power converter according to an embodiment of this application;
FIG. 4 is a diagram of a structure of a thermally conductive base plate according to an embodiment of this application;
FIG. 5 is a diagram of a structure of a thermally conductive base plate according to another embodiment of this application;
FIG. 6 is a diagram of structures of a thermally conductive base plate and a first metal layer in a power module according to an embodiment of this application;
FIG. 7 is a diagram of a structure of a power module according to an embodiment of this application;
FIG. 8 is a diagram of structures of reinforcing structures with different projection shapes in a thermally conductive base plate according to an embodiment of this application;
FIG. 9 is a diagram of a structure of a thermally conductive base plate according to another embodiment of this application;
FIG. 10 is a diagram of a structure of another thermally conductive base plate according to another embodiment of this application;
FIG. 11 is a diagram of a structure in which a groove is provided on a thermally conductive base plate according to an embodiment of this application;
FIG. 12 is a diagram of a partial structure in which grooves of different sizes are provided on a thermally conductive base plate according to an embodiment of this application;
FIG. 13 is a diagram of a three-dimensional structure of a thermally conductive base plate according to an embodiment of this application;
FIG. 14 is a diagram of a structure of a power module according to another embodiment of this application;
FIG. 15 is a diagram of a structure of a power module according to still another embodiment of this application;
FIG. 16 is a diagram of structures of bosses of different shapes on a thermally conductive base plate according to an embodiment of this application;
FIG. 17 is a diagram of a structure in which spaced semi-enclosed bosses are disposed on a thermally conductive base plate according to an embodiment of this application;
FIG. 18 is a diagram of a partial structure of a groove in a thermally conductive base plate according to an embodiment of this application;
FIG. 19 is a diagram of a structure in which a quadrangular groove is provided on a thermally conductive base plate according to an embodiment of this application; and
FIG. 20 is a diagram of a structure in which spaced semi-enclosed grooves are provided on a thermally conductive base plate according to an embodiment of this application.

### Reference numerals:

10: circuit board; 20: power module; 21: chip; 22: connection terminal; 23: molding body; 24: connection layer; 25: ceramic substrate; 251: first metal layer; 2511: corner; 252: insulation layer; 253: second metal layer; 26: thermally conductive base plate; 261: reinforcing structure; 261a: containing space; 261b: first end; 261c: second end; 262: connection portion; 263: groove; 2631: bottom wall; 2632: first side wall; 2633: second side wall; 2634: notch; 264: boss; 265: accommodating space; 27: cover plate; 100: power converter; 100a: photovoltaic inverter; 100b: power conversion system; 200: wheel; 300: engine; 400: battery assembly; 500: photovoltaic module; 600: box-type substation; 700: booster station; 800: power grid; 900: energy storage system; 1000: vehicle.

### DESCRIPTION OF EMBODIMENTS

To make objectives, technical solutions, and advantages of this application clearer, the following further describes this application in detail with reference to the accompanying drawings.

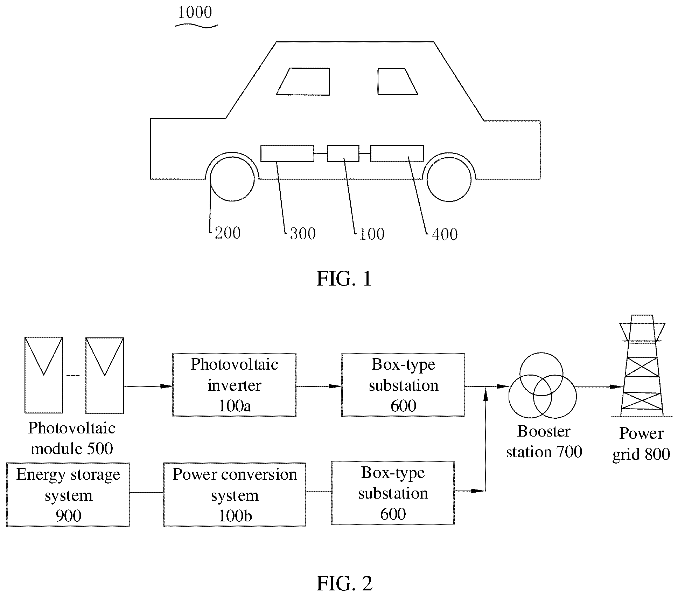

Refer to FIG. 1. FIG. 1 is a diagram of a structure of a vehicle 1000 according to an embodiment of this application. Embodiments of this application provide the vehicle 1000. The vehicle 1000 includes a power converter 100, a wheel 200, an engine 300, and a battery assembly 400. The power converter 100 is connected to the engine 300 and the battery assembly 400. The power converter 100 may be an inverter or a rectifier. The inverter is configured to convert a direct current of the battery assembly 400 into an alternating current and supply power to the engine 300, and the engine 300 drives the wheel 200 to rotate. The rectifier is configured to convert an alternating current into a direct current.

The vehicle 1000 may include an electric vehicle, a hybrid electric vehicle, a range extended electric vehicle, a plug-in hybrid electric vehicle, a fuel cell vehicle, and the like. This is not specifically limited.

Specifically, the battery assembly 400 is electrically connected to the engine 300 through the power converter 100, and the battery assembly 400 provides electric energy for the engine 300. The engine 300 converts the electric energy into mechanical energy, to provide kinetic energy for the vehicle 1000 and drive the wheel 200 to move.

Refer to FIG. 2. FIG. 2 is a diagram of networking of a photovoltaic energy storage system according to an embodiment of this application. A power converter 100 may be further used in the photovoltaic energy storage system. The photovoltaic energy storage system includes a photovoltaic inverter 100a, a power conversion system 100b, a photovoltaic module 500, box-type substations 600, a booster station 700, a power grid 800, and an energy storage system 900. The photovoltaic module 500 converts solar energy into a direct current by using photovoltaic effect. The photovoltaic inverter 100a converts the direct current output by the photovoltaic module 500 into an alternating current, and further transfers the alternating current to a box-type substation 600. After converting a low-voltage alternating current output by the photovoltaic inverter 100a into a medium-voltage alternating current, the box-type substation 600 further transfers the alternating current to the booster station 700 (the power grid 800), or a box-type substation 600 corresponding to the energy storage system 900. The energy storage system 900 is configured to: store unstable electric energy from the photovoltaic module 500, and output stable electric energy to the power grid 800 by using the power conversion system 100b and the corresponding box-type substation 600. The photovoltaic inverter 100a and the power conversion system 100b are core devices for power conversion, and are collectively referred to as the power converter 100.

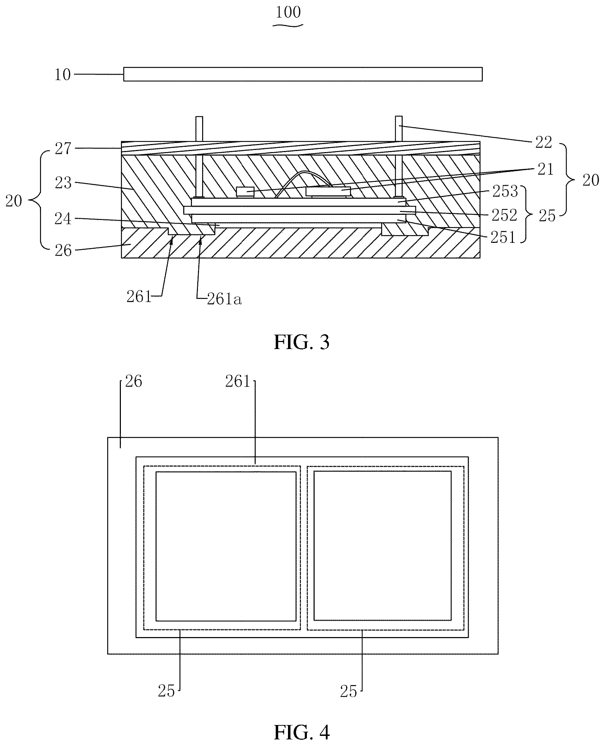

Refer to FIG. 3. FIG. 3 is a diagram of a structure of a power converter 100 according to an embodiment of this application. The power converter 100 includes a circuit board 10 and a power module 20. The power module 20 is disposed on the circuit board 10. There may be a plurality of power modules 20, and the plurality of power modules 20 are electrically connected to each other.

The power module 20 includes a chip 21, a connection terminal 22, a molding body 23, a connection layer 24, a ceramic substrate 25, and a thermally conductive base plate 26. The thermally conductive base plate 26, the connection layer 24, and the ceramic substrate 25 are sequentially stacked. The thermally conductive base plate 26 is fastened to the ceramic substrate 25 by using the connection layer 24. The chip 21 and the connection terminal 22 are disposed on a surface on a side that is of the ceramic substrate 25 and that faces away from the thermally conductive base plate 26. The molding body 23 is configured to package the thermally conductive base plate 26, the ceramic substrate 25, the chip 21, the connection layer 24, and the connection terminal 22. The molding body 23 wraps the connection layer 24, the ceramic substrate 25, the chip 21, and a part of the connection terminal 22.

Optionally, the power module 20 may further include a cover plate 27. The cover plate 27 covers the molding body 23.

The chip 21 may include an active component and a passive component. The active component includes one or more of a power integrated circuit (C), an insulated gate bipolar transistor (IGBT), a metal-oxide-semiconductor field-effect transistor (MOSFET), and a diode. The passive component includes one or more of a capacitor and a resistor. A chip 21 may be connected to a chip 21 through a control/through-current line. The control/through-current line includes but is not limited to a bonding line (for example, an aluminium line, a copper line, a silver line, and an alloy line thereof) or a metal (for example, copper, silver, and aluminium) strip/belt. The chip 21 may dissipate heat to outside of the power module 20 through the ceramic substrate 25, the connection layer 24, and the thermally conductive base plate 26, or the chip 21 may dissipate heat to outside of the power module 20 through the ceramic substrate 25, the molding body 23, and the thermally conductive base plate 26.

The connection terminal 22 is configured to connect to an external component. The connection terminal 22 includes but is not limited to a pin, a through-current busbar, a bolt terminal, or the like.

The molding body 23 may be a molding compound or a potting compound. The molding body 23 is filled on a side that is of the thermally conductive base plate 26 and that faces the ceramic substrate 25, and packages the ceramic substrate 25, the chip 21, and the connection terminal 22 in an insulated manner. Heat generated by the chip 21 may be conducted to the outside of the power module 20 through the molding body 23.

The connection layer 24 may be configured to connect the thermally conductive base plate 26 and the ceramic substrate 25, and may be a solder of various components, a nano-silver glue, a silver or copper sintered material, a diffusion soldering layer, or the like. The connection layer 24 fastens the ceramic substrate 25 to the thermally conductive base plate 26 through soldering.

The ceramic substrate 25 includes a first metal layer 251, an insulation layer 252, and a second metal layer 253. In an arrangement direction of the ceramic substrate 25 and the thermally conductive base plate 26, the first metal layer 251 and the second metal layer 253 are respectively disposed on two opposite sides of the insulation layer 252, and the first metal layer 251 is located on a side that is of the insulation layer 252 and that faces the thermally conductive base plate 26. The second metal layer 253 is configured to connect one or more chips 21 and the connection terminal 22. Both the connection terminal 22 and the chip 21 may be fastened to the second metal layer 253 by using a solder.

The ceramic substrate 25 may be a single/double-sided copper-clad (DBC or DCB) ceramic substrate, an active metal brazing (AMB) copper-clad substrate, an insulated metal substrate (IMS), a substrate, a printed circuit board (PCB) 10, or another substrate for packaging.

Materials of the first metal layer 251 and the second metal layer 253 may be copper, aluminium, or other metal thermally conductive materials. The materials of the first metal layer 251 and the second metal layer 253 may be the same or may be different.

An outer edge of the insulation layer 252 protrudes a part relative to outer edges of the first metal layer 251 and the second metal layer 253. A material of the insulation layer 252 may be Al₂O₃, Si₃N₄, or AlN, and the insulation layer 252 has a good thermal conductivity coefficient. This helps improve a heat dissipation capability of the power module 20.

For a power module packaged in a molding form, a molding compound imposes a large squeezing force on a side surface of a ceramic substrate. The ceramic substrate includes a ceramic insulation layer and a lower copper layer. In addition, an outer edge of the ceramic insulation layer usually protrudes relative to an outer edge of the lower copper layer. A shape of a joint between a side surface of the lower copper layer and the ceramic insulation layer changes sharply. This is prone to a stress concentration problem. The ceramic insulation layer has low force strength, and is prone to a risk of layering or cracking. This cannot meet a long-term reliability requirement of the power module.

In this application, a reinforcing structure 261 is formed on the side that is of the thermally conductive base plate 26 and that faces the ceramic substrate 25. The reinforcing structure 261 is located on a side portion of the connection layer 24 in a direction perpendicular to an arrangement direction of the thermally conductive base plate 26 and the connection layer 24. A wall surface of the reinforcing structure 261 and a surface that is of the first metal layer 251 and that faces the thermally conductive base plate 26 jointly enclose a containing space 261a. The containing space 261a is used to be filled with the molding body 23. In this way, the molding body 23 is filled between the thermally conductive base plate 26 and the first metal layer 251. The molding body 23 filled between the thermally conductive base plate 26 and the first metal layer 251 provides a support force for the surface that is of the first metal layer 251 and that faces the thermally conductive base plate 26. In addition, the molding body 23 wraps the surface that is of the first metal layer 251 and that faces the thermally conductive base plate 26 and a joint between a side surface of the first metal layer 251 and the insulation layer 252, and transfers a stress concentration position on the ceramic substrate 25 from the joint between the side surface of the first metal layer 251 and the insulation layer 252 to the surface that is of the first metal layer 251 and that faces the thermally conductive base plate 26. This effectively reduces a case in which the molding body 23 squeezes only the joint between the side surface of the first metal layer 251 and the insulation layer 252, optimizes stress distribution inside the power module 20, reduces a risk of layering or cracking of the insulation layer 252, and helps improve long-term reliability of the power module 20.

In addition, the reinforcing structure 261 is located on the side portion of the connection layer 24, so that the molding body 23 filled between the thermally conductive base plate 26 and the first metal layer 251 is disposed around the connection layer 24, and the molding body 23 can wrap, as much as possible, a side surface of the ceramic substrate 25 and a surface that is of the ceramic substrate 25 and that faces the thermally conductive base plate 26, thereby further reducing a risk of layering or cracking of the insulation layer 252.

A material of the thermally conductive base plate 26 includes but is not limited to a high thermally conductive metal material, for example, copper or aluminum. This helps improve a heat dissipation capability of the power module 20.

In this application, each thermally conductive base plate 26 may be connected to one or more ceramic substrates 25. When a plurality of ceramic substrates 25 are connected to the thermally conductive base plate 26, the plurality of ceramic substrates 25 are spaced apart on the thermally conductive base plate 26. A quantity of the ceramic substrates 25 may be determined based on electrical and structural designs.

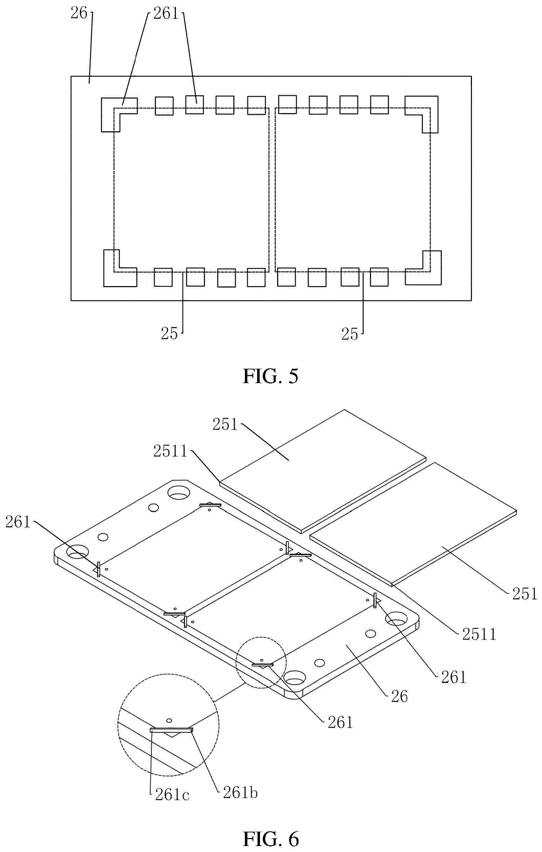

With reference to FIG. 4 and FIG. 5, FIG. 4 is a diagram of a structure of a thermally conductive base plate 26 according to an embodiment of this application, and FIG. 5 is a diagram of a structure of a thermally conductive base plate 26 according to another embodiment of this application. The reinforcing structure 261 is disposed on an outer edge (that is, the side portion) of the connection layer 24, and the reinforcing structure 261 is distributed circumferentially along the outer edge of the connection layer 24. For example, when there is one reinforcing structure 261, the reinforcing structure 261 extends circumferentially along the outer edge of the connection layer 24 to form a closed-loop structure, and the reinforcing structure 261 is of a fully-enclosed structure, as shown in FIG. 4; or the reinforcing structure 261 extends circumferentially along the outer edge of the connection layer 24 to form an annular structure with an opening. For another example, when there are a plurality of reinforcing structures 261, the plurality of reinforcing structures 261 are spaced apart circumferentially along the outer edge of the connection layer 24, as shown in FIG. 5. Through this arrangement, the molding body 23 can wrap, as much as possible, the side surface of the ceramic substrate 25 and the surface that is of the ceramic substrate 25 and that faces the thermally conductive base plate 26, thereby further reducing a risk of layering or cracking of the insulation layer 252.

With reference to FIG. 6, FIG. 6 is a diagram of a structure of the thermally conductive base plate 26 and the first metal layer 251 in the power module 20 according to an embodiment of this application. In an embodiment, the first metal layer 251 has a plurality of corners 2511. When the plurality of reinforcing structures 261 are spaced apart on the outer edge of the connection layer 24, each corner 2511 corresponds to one reinforcing structure 261. One end of the reinforcing structure 261 extends toward one edge of the corner 2511, and the other end of the reinforcing structure 261 extends toward the other adjacent edge of the corner 2511. A shape of the corner 2511 of the first metal layer 251 changes sharply. This is prone to a stress concentration problem and a risk of cracking of the insulation layer 252 at a corresponding position. At the corner 2511 of the first metal layer 251, the reinforcing structure 261 extending to two adjacent edges of the corner 2511 is disposed, so that the molding body 23 filled between the thermally conductive base plate 26 and the first metal layer 251 can extend to the two adjacent edges of the corner 2511, a risk of layering or cracking of the insulation layer 252 at the corner 2511 is reduced, and reliability of the power module 20 is improved.

With reference to FIG. 3, for example, a surface that is of the reinforcing structure 261 and that faces the corner 2511 semi-encloses a corner 2511. In other words, an outer edge of a side that is of an orthographic projection of the reinforcing structure 261 and that is away from the connection layer 24 is located outside an outer edge of an orthographic projection of the corner 2511 in an arrangement direction of the thermally conductive base plate 26 and the ceramic substrate 25. This includes that one end (a first end 261b shown in FIG. 6) of the reinforcing structure 261 is located outside one edge of the corner 2511, and the other end (a second end 261c shown in FIG. 6, where the second end 261c and the first end 261b are disposed opposite to each other) of the reinforcing structure 261 is located outside the other adjacent edge of the corner 2511.

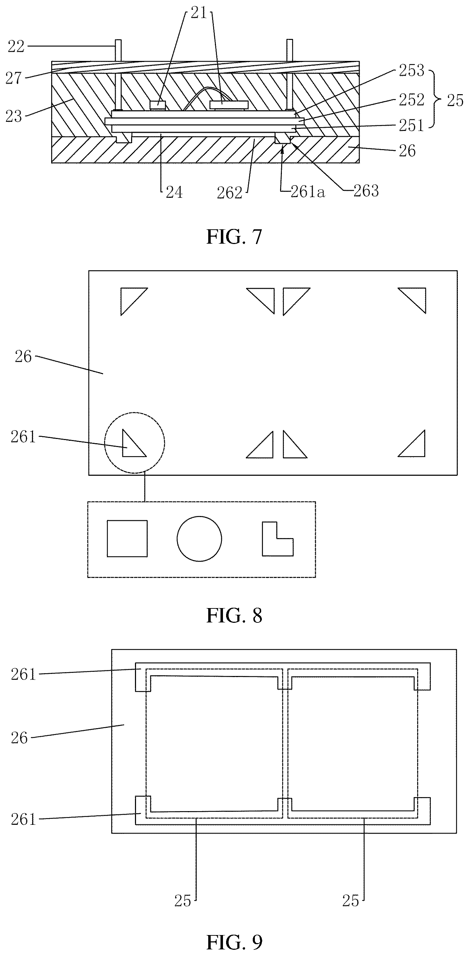

With reference to FIG. 7, FIG. 7 is a diagram of a structure of a power module 20 according to an embodiment of this application. As shown in FIG. 7, it may be understood that, an outer edge of an orthographic projection of the reinforcing structure 261 may be located within an outer edge of an orthographic projection of the corner 2511 in an arrangement direction of the thermally conductive base plate 26 and the ceramic substrate 25.

With reference to FIG. 8, FIG. 8 is a diagram of structures of reinforcing structures 261 with different projection shapes in the thermally conductive base plate 26 according to an embodiment of this application. As shown in FIG. 8, in the arrangement direction of the thermally conductive base plate 26 and the ceramic substrate 25, a shape of an outer contour of an orthographic projection of a reinforcing structure 261 may be any one of a triangle, a rectangle, a circle, or a combination of the foregoing plurality of shapes. This is not specifically limited.

With reference to FIG. 5, further, a plurality of reinforcing structures 261 are spaced apart between two adjacent corners 2511, and reinforcing structures 261 on the thermally conductive base plate 26 are arranged in an annular discontinuous manner. In other words, the plurality of reinforcing structures 261 enclose an annular discontinuous structure. For example, when the first metal layer 251 is of a rectangular structure, a plurality of reinforcing structures 261 spaced apart are disposed between two adjacent corners 2511 in a long-side direction of the first metal layer 251, as shown in FIG. 5; or a plurality of reinforcing structures 261 spaced apart are disposed between two adjacent corners 2511 in a short-side direction of the first metal layer 251; or a plurality of reinforcing structures 261 spaced apart are disposed between any two adjacent corners 2511 along a circumference of an outer edge of the first metal layer 251.

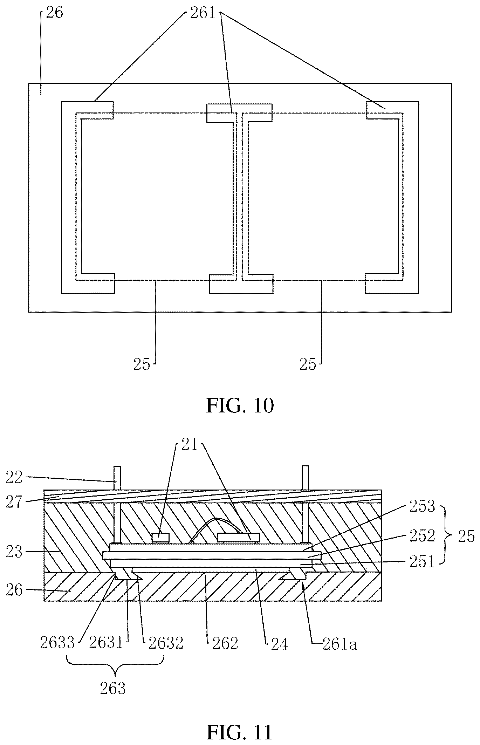

With reference to FIG. 9 and FIG. 10, FIG. 9 is a diagram of a structure of a thermally conductive base plate 26 according to another embodiment of this application, and FIG. 10 is a diagram of a structure of another thermally conductive base plate 26 according to another embodiment of this application. In another embodiment, the reinforcing structure 261 is of a long-strip structure, and an end portion of the reinforcing structure 261 is bent and partially encloses the corner 2511 of the first metal layer 251. A structure in which the reinforcing structure 261 encloses the corner 2511 is similar to a design of the reinforcing structure 261 in the previous embodiment. In other words, two reinforcing structures 261 at two corners 2511 and a reinforcing structure 261 between the two corners 2511 are connected as an integrated structure. For example, when the first metal layer 251 is of a rectangular structure, reinforcing structures 261 of an integrated structure may be of a long-side semi-enclosed structure, as shown in FIG. 9, or may be of a short-side semi-enclosed structure, as shown in FIG. 10.

When there are a plurality of ceramic substrates 25, one or more reinforcing structures 261 may be disposed on an outer circle of each ceramic substrate 25, and reinforcing structures 261 between two adjacent ceramic substrates 25 may overlap, as shown in FIG. 4, FIG. 9, and FIG. 10. Optionally, when there are a plurality of ceramic substrates 25, reinforcing structures 261 between two adjacent ceramic substrates 25 may alternatively be spaced apart, as shown in FIG. 6 and FIG. 8; or side portions between two adjacent ceramic substrates 25 are located in a middle position of the thermally conductive base plate 26, stress at this position is small, and a reinforcing structure 261 may not be disposed on a part of the thermally conductive base plate 26 between the two adjacent ceramic substrates 25, as shown in FIG. 5.

As shown in FIG. 7, in an embodiment, the reinforcing structure 261 includes a groove 263. The groove 263 is filled with the molding body 23. Specifically, a surface that is of the thermally conductive base plate 26 and that faces the ceramic substrate 25 is recessed to form the groove 263, and wall surfaces of the groove 263 and the surface that is of the first metal layer 251 and that faces the thermally conductive base plate 26 enclose the containing space 261a. The groove 263 is formed on the thermally conductive base plate 26, and a structure is simple and easy to implement. Arrangement of the groove 263 enables the molding body 23 filled between the thermally conductive base plate 26 and the first metal layer 251 to extend to an outer circumference of the connection layer 24, so that a contact area between the molding body 23 and the surface that is of the first metal layer 251 and that faces the thermally conductive base plate 26 is maximized. This increases a contact area between the molding body 23 and the first metal layer 251, optimizes stress distribution inside the power module 20, reduces a risk of layering or cracking of the insulation layer 252, and improves reliability of the power module 20.

In addition, a connection portion 262 is formed on the thermally conductive base plate 26, and the connection portion 262 protrudes toward the ceramic substrate 25 relative to a bottom of the groove 263. The connection portion 262 is configured to place the connection layer 24, and the groove 263 surrounds the connection portion 262. Through this arrangement, an extension distance of the connection layer 24 can be effectively limited by using an outer edge of the connection portion 262, and a possibility that the connection layer 24 extends to the side surface of the first metal layer 251 is reduced. A depth of the groove 263 may be designed based on a thickness of the thermally conductive base plate 26. This is not specifically limited.

With reference to FIG. 11, FIG. 11 is a diagram of a structure in which the groove 263 is provided on the thermally conductive base plate 26 according to an embodiment of this application. The groove 263 includes a bottom wall 2631, a first side wall 2632, and a second side wall 2633. The first side wall 2632 is connected to an edge of a side that is of the bottom wall 2631 and that faces the connection layer 24, the second side wall 2633 is connected to an edge of a side that is of the bottom wall 2631 and that is away from the connection layer 24, and the first side wall 2632, the bottom wall 2631, and the second side wall 2633 jointly enclose the groove 263. The bottom wall 2631 of the groove 263 is the bottom of the groove 263.

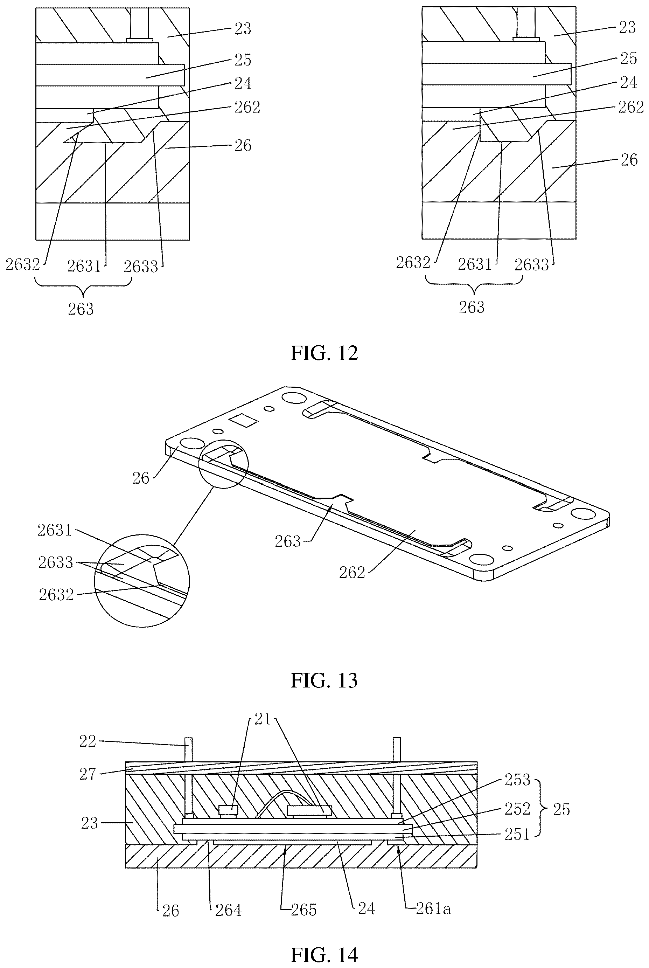

With reference to FIG. 12, FIG. 12 is a diagram of a partial structure in which grooves 263 of different sizes are provided on the thermally conductive base plate 26 according to an embodiment of this application. For example, a first side wall 2632 is inclined relative to a joint between the first side wall 2632 and a bottom wall 2631 toward of a second side wall 2633; and/or the second side wall 2633 is inclined relative to a joint between the second side wall 2633 and the bottom wall 2631 away from a side of the first side wall 2632.

For example, when the first side wall 2632 is inclined relative to the joint between the first side wall 2632 and the bottom wall 2631 toward of the second side wall 2633, the second side wall 2633 may be perpendicular to the bottom wall 2631, and a groove 263 is of a dovetail groove structure, as shown in FIG. 11; or the second side wall 2633 may be inclined relative to the joint between the second side wall 2633 and the bottom wall 2631 toward the first side wall 2632, and a groove 263 is also of a dovetail groove structure. For another example, when the second side wall 2633 is inclined relative to the joint between the second side wall 2633 and the bottom wall 2631 away from the side of the first side wall 2632, a groove 263 forms a chamfer structure at the second side wall 2633, the first side wall 2632 may be perpendicular to the bottom wall 2631, and the groove 263 is a groove with a chamfer structure as a whole, as shown in a right figure of FIG. 12; or the first side wall 2632 may be inclined relative to the joint between the first side wall 2632 and the bottom wall 2631 away from the second side wall 2633, the groove 263 forms a chamfer structure at the first side wall 2632, and the groove 263 is a groove with a chamfer structures as a whole. For another example, the first side wall 2632 is inclined relative to the joint between the first side wall 2632 and the bottom wall 2631 toward of the second side wall 2633, the second side wall 2633 is inclined relative to the joint between the second side wall 2633 and the bottom wall 2631 away from the side of the first side wall 2632, and a groove 263 forms a chamfer structure at the second side wall 2633. In this way, the groove 263 is a dovetail groove with the chamfer structure, as shown in a left figure of FIG. 12.

With reference to FIG. 11 and FIG. 13, FIG. 13 is a diagram of a three-dimensional structure of the thermally conductive base plate 26 according to an embodiment of this application. A first side wall 2632 is inclined relative to a joint between the first side wall 2632 and a bottom wall 2631 toward of a second side wall 2633. In other words, an outer edge of a side that is of an orthographic projection of a groove 263 and that is close to the connection layer 24 is located within an outer edge of an orthographic projection of the connection portion 262 in the arrangement direction of the thermally conductive base plate 26 and the ceramic substrate 25, as shown in FIG. 11. Through this arrangement, the groove 263 is of a dovetail groove structure at the first side wall 2632. Even if the molding body 23 and the thermally conductive base plate 26 have risks of layering or cracking, positions of layering or cracking may be concentrated at the joint between the first side wall 2632 and the bottom wall 2631, and is not easily extended to the connection layer 24 to cause layering or cracking of the connection layer 24. This helps improve reliability of connections between the thermally conductive base plate 26 and the connection layer 24, and between the first metal layer 251 and the connection layer 24.

The second side wall 2633 is inclined relative to a joint between the second side wall 2633 and the bottom wall 2631 away from a side of the first side wall 2632. Through this arrangement, the groove 263 forms a chamfer structure at the second side wall 2633, and transition of an edge of a side that is of the groove 263 and that is away from the connection layer is gentle, that is, transition of the joint between the second side wall 2633 and the bottom wall 2631 is soft; and transition between an end that is of the second side wall 2633 and that is away from the bottom wall 2631 and a surface that is of the thermally conductive base plate 26 and that is closest to the first metal layer 251 is also soft. This helps reduce stress of the molding body 23 on the side that is of the groove 263 and that is away from the connection layer 24, and reduce a risk of cracking of the molding body 23.

Further, the end that is of the second side wall 2633 and that is away from the bottom wall 2631 and the surface that is of the thermally conductive base plate 26 and that is closest to the first metal layer 251 are in arc transition, thereby further reducing stress of the molding body 23 at this position and reducing a risk of cracking of the molding body 23.

With reference to FIG. 14, FIG. 14 is a diagram of a structure of a power module 20 according to another embodiment of this application. In the another embodiment, the reinforcing structure 261 includes a boss 264. The boss 264 protrudes toward the first metal layer 251, and the boss 264 is located on the side portion of the connection layer 24. In this way, there is a spacing between the first metal layer 251 and a part that is of the thermally conductive base plate 26 and on which no boss 264 is disposed, so that a surface that is of the boss 264 and that faces away from the connection layer 24, a surface that is of the thermally conductive base plate 26 and that faces the first metal layer 251, and the surface that is of the first metal layer 251 and that faces the thermally conductive base plate 26 jointly enclose the containing space 261a. The molding body 23 can extend to a side that is of the first metal layer 251 and that faces the thermally conductive base plate 26, so that the stress concentration position on the ceramic substrate 25 is transferred to the surface that is of the first metal layer 251 and that faces the thermally conductive base plate 26. This reduces a risk of layering or cracking of the insulation layer 252 and helps improve reliability of the power module 20.

In addition, the boss 264 is located on the side portion of the connection layer 24, and the boss 264 may limit the connection layer 24, to effectively reduce a possibility that the connection layer 24 extends to the side surface of the first metal layer 251. The bosses 264 are disposed in a same manner as distribution of the foregoing reinforcing structure 261. In this way, one or more bosses 264 enclose an accommodating space 265, and the connection layer 24 is placed in the accommodating space 265, so that the connection layer 24 is limited.

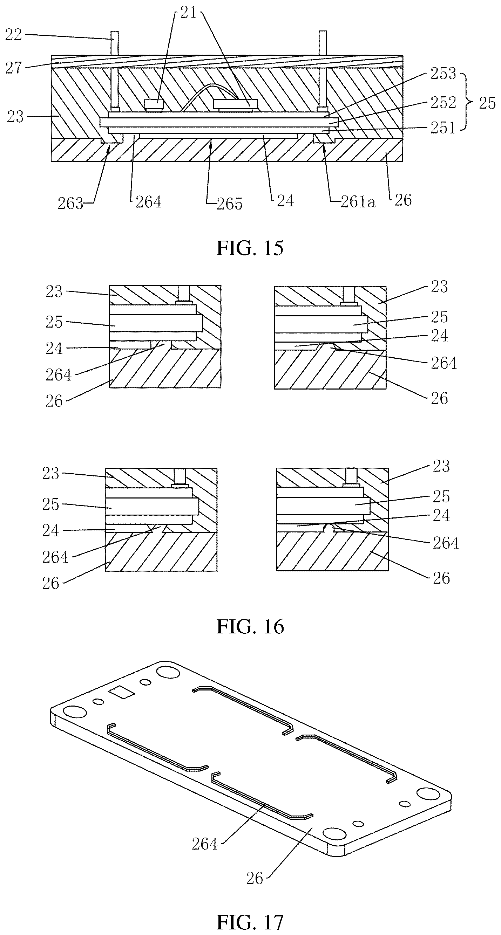

With reference to FIG. 15, FIG. 15 is a diagram of a structure of a power module 20 according to still another embodiment of this application. In the still another embodiment, the reinforcing structure 261 includes a boss 264 and a groove 263. Both the boss 264 and the groove 263 are located on the side portion of the connection layer 24, and the boss 264 is located between the connection layer 24 and the groove 263. An orthographic projection of the boss 264 is located within an outer edge of an orthographic projection of the first metal layer 251 in the arrangement direction of the thermally conductive base plate 26 and the ceramic substrate 25, and the groove 263 is filled with the molding body 23.

The boss 264 and the groove 263 are sequentially disposed on a periphery of the connection layer 24. A surface that is of the boss 264 and that faces away from the connection layer 24, the surface that is of the first metal layer 251 and that faces the thermally conductive base plate 26, and wall surfaces of the groove jointly enclose the containing space 261a. The boss 264 may limit the connection layer 24. In addition, arrangement of the groove 263 further increases a depth of the containing space 261a. In this way, the molding body 23 is filled more on a side that is of the first metal layer 251 and that faces the thermally conductive base plate 26. This enhances support for the ceramic substrate 25, reduces a risk of layering or cracking of the ceramic substrate 25, and helps improve reliability of the power module 20.

In an embodiment in which the reinforcing structure 261 includes a boss 264, a surface that is of the boss 264 and that faces the first metal layer 251 is attached to the first metal layer 251. In this way, the boss 264 can support the first metal layer 251, and flow in a soldering process of the connection layer 24 to a side that is of the boss 264 and that faces away from the connection layer 24 is effectively reduced, to effectively limit the connection layer 24. Optionally, when a thickness of the connection layer 24 in the arrangement direction of the thermally conductive base plate 26 and the ceramic substrate 25 is greater than a height of the boss 264, there is a spacing between the first metal layer 251 and the surface that is of the boss 264 and that faces the first metal layer 251.

Further, in the arrangement direction of the thermally conductive base plate 26 and the ceramic substrate 25, the orthographic projection of the boss 264 is located within the outer edge of the orthographic projection of the first metal layer 251, and the molding body 23 can be effectively filled between the first metal layer 251 and the thermally conductive base plate 26, to wrap the side surface of the ceramic substrate 25. This helps improve reliability of the power module 20.

With reference to FIG. 16, FIG. 16 is a diagram of a structure of bosses 264 of different shapes on the thermally conductive base plate 26 according to an embodiment of this application. A cross section of a boss 264 may be a trapezoidal structure with a wide upper part and a narrow lower part, a trapezoidal structure with a narrow upper part and a wide lower part, an arc-shaped structure, a rectangular structure, or the like. This is not specifically limited. The upper and lower parts are two opposite sides in the arrangement direction of the thermally conductive base plate 26 and the ceramic substrate 25.

With reference to FIG. 6 and FIG. 17, FIG. 17 is a diagram of a structure in which spaced semi-enclosed bosses 264 are disposed on the thermally conductive base plate 26 according to an embodiment of this application. As described above, there may be one or more bosses 264. When there is one boss 264, the boss 264 surrounds the connection layer 24, and the boss 264 is of a closed-loop structure, to form a fully-enclosed boss 264, or the boss 264 is of an annular structure with an opening. When there are a plurality of bosses 264, the plurality of bosses 264 may be quadrangular bosses 264 (as shown in FIG. 6), spaced semi-enclosed bosses 264 (as shown in FIG. 16 or FIG. 10), or annular discontinuous bosses 264. Distribution arrangement of the annular discontinuous bosses 264 is similar to annular discontinuous distribution arrangement of the foregoing reinforcing structures 261. Details are not described again.

In an embodiment in which the reinforcing structure 261 includes a groove 263, the groove 263 may be a dovetail groove, a rectangular groove, a triangular groove, or a groove of another shape. At least a part of an orthographic projection of the groove 263 is located within an outer edge of an orthographic projection of the first metal layer 251 in the arrangement direction of the thermally conductive base plate 26 and the ceramic substrate 25. For example, a part of the orthographic projection of the groove 263 is located within the outer edge of the orthographic projection of the first metal layer 251, and the other part is located outside the outer edge of the orthographic projection of the first metal layer 251, as shown in FIG. 15. For another example, all the orthographic projection of the groove 263 is located within the outer edge of the orthographic projection of the first metal layer 251, as shown in FIG. 7 and FIG. 11. Through this arrangement, the molding body 23 can be filled between the thermally conductive base plate 26 and the first metal layer 251 and at least partially located within an outer edge of the first metal layer 251, so that the stress concentration position on the ceramic substrate 25 is transferred to the surface that is of the first metal layer 251 and that faces the thermally conductive base plate 26. This reduces a risk of layering or cracking of the insulation layer 252 and helps improve reliability of the power module 20.

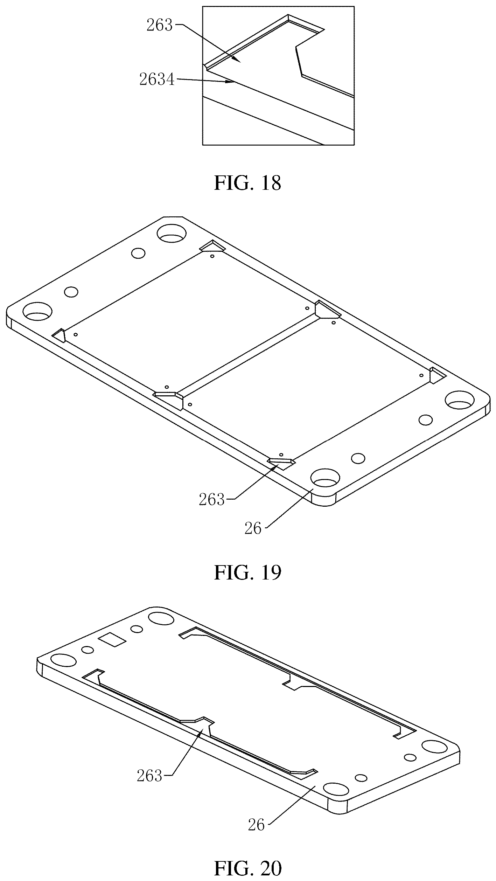

With reference to FIG. 15 and FIG. 18, FIG. 18 is a diagram of a partial structure of a groove 263 in the thermally conductive base plate 26 according to an embodiment of this application. For example, an edge that is of an orthographic projection of the groove 263 and that is away from the connection layer 24 is located outside an outer edge of an orthographic projection of the first metal layer 251 in the arrangement direction of the thermally conductive base plate 26 and the ceramic substrate 25. As shown in FIG. 18, a part of the edge that is of the orthographic projection of the groove 263 and that is away from the connection layer 24 may extend to a side edge of the thermally conductive base plate 26, that is, the groove 263 has a notch 2634. In this way, an outer edge of a side that is of the groove 263 and that is away from the connection layer 24 is staggered with an outer edge of the first metal layer 251, a position at which a shape of the side surface of the ceramic substrate 25 changes sharply is staggered with a position at which the molding body 23 changes sharply, a contact area between the molding body 23 and the first metal layer 251 is increased, stress distribution inside the power module 20 is optimized, a risk of layering or cracking of the insulation layer 252 is reduced, and reliability of the power module 20 is improved.

With reference to FIG. 19 and FIG. 20, FIG. 19 is a diagram of a structure in which a quadrangular groove 263 is provided on the thermally conductive base plate 26 according to an embodiment of this application, and FIG. 20 is a diagram of a structure in which spaced semi-enclosed grooves 263 are provided on the thermally conductive base plate 26 according to an embodiment of this application. Similarly, there may be one or more grooves 263. When there is one groove 263, the groove 263 surrounds the connection layer 24, and the groove 263 is of a closed-loop structure, to form a fully-enclosed groove 263, or an annular structure with an opening is formed between two end portions of the groove 263. When there are a plurality of grooves 263, the plurality of grooves 263 may be quadrangular grooves 263 (as shown in FIG. 19), spaced semi-enclosed grooves 263 (as shown in FIG. 20 or FIG. 10), or annular discontinuous grooves 263. Distribution arrangement of the annular discontinuous grooves 263 is similar to annular discontinuous distribution arrangement of the foregoing reinforcing structures 261. Details are not described again.

In conclusion, based on the structure of the thermally conductive base plate 26 provided in this application, stress distribution inside the power module 20 in a reliability test or a normal application working condition is effectively improved, and a risk of layering or cracking of the ceramic substrate 25 is reduced. This helps improve application reliability of the ceramic substrate 25 and improve heat dissipation performance and reliability of the power module 20. In addition, after a stress risk of the power module 20 is reduced, an area of the power module 20 can be effectively increased, a power upper limit of a single power module 20 is further increased, and costs per watt of the power module 20 are reduced.

In this application, unless otherwise specified and limited, terms "connect", "fasten", and the like should be understood in a broad sense. For example, "fasten" may indicate a fixed connection, a detachable connection, or an integrated connection, may indicate a mechanical connection or an electrical connection, or may indicate a direct connection, an indirect connection through an intermediate medium, internal communication between two elements, or an interaction relationship between two elements, unless otherwise specified. A person of ordinary skill in the art may understand specific meanings of the foregoing terms in this application based on specific situations.

It should be understood that "first", "second", and various numbers in this specification are merely used for differentiation for ease of description, but are not intended to limit the scope of this application.

It should be understood that sequence numbers of the foregoing processes do not mean execution sequences in various embodiments of this application. The execution sequences of the processes should be determined based on functions and internal logic of the processes, and should not be construed as any limitation on the implementation processes of embodiments of this application.

The foregoing embodiments are merely intended for describing the technical solutions of this application other than limiting this application. Although this application is described in detail with reference to the foregoing embodiments, a person of ordinary skill in the art should understand that modifications may still be made to the technical solutions described in the foregoing embodiments or equivalent replacements may still be made to some technical features thereof, without departing from the scope of the technical solutions of embodiments of this application.

## Claims

1. A power module, comprising a thermally conductive base plate, a ceramic substrate, a chip, a molding body, and a connection layer, wherein the thermally conductive base plate, the connection layer, the ceramic substrate, and the chip are sequentially stacked, the molding body wraps the ceramic substrate and the chip, the ceramic substrate comprises an insulation layer and a first metal layer, and the first metal layer is disposed between the insulation layer and the connection layer; and
a reinforcing structure is formed on a side that is of the thermally conductive base plate and that faces the ceramic substrate, the reinforcing structure is located on a side portion of the connection layer in a direction perpendicular to a stacking direction of the thermally conductive base plate and the connection layer, a wall surface of the reinforcing structure and a surface that is of the first metal layer and that faces the thermally conductive base plate enclose a containing space, and the molding body fills the containing space.

2. The power module according to claim 1, wherein there are a plurality of reinforcing structures, and the plurality of reinforcing structures are disposed around the connection layer and spaced apart.

3. The power module according to claim 2, wherein the first metal layer has a plurality of corners, each corner corresponds to one of the reinforcing structures, one end of the reinforcing structure extends toward one edge of the corner, and the other end of the reinforcing structure extends toward the other adjacent edge of the corner.

4. The power module according to claim 1, wherein the reinforcing structure comprises a groove, and the groove is filled with the molding body.

5. The power module according to claim 4, wherein an edge that is of an orthographic projection of the groove and that is away from the connection layer is located outside an outer edge of an orthographic projection of the first metal layer in an arrangement direction of the thermally conductive base plate and the ceramic substrate.

6. The power module according to claim 4, wherein at least a part of an orthographic projection of the groove is located within an outer edge of an orthographic projection of the first metal layer in an arrangement direction of the thermally conductive base plate and the ceramic substrate.

7. The power module according to claim 1, wherein the reinforcing structure comprises a boss, the boss protrudes toward the first metal layer, the boss is located on the side portion of the connection layer, a surface that is of the boss and that faces away from the connection layer, a surface that is of the thermally conductive base plate and that faces the first metal layer, and the surface that is of the first metal layer and that faces the thermally conductive base plate enclose the containing space, and an orthographic projection of the boss is located within an outer edge of an orthographic projection of the first metal layer in an arrangement direction of the thermally conductive base plate and the ceramic substrate.

8. The power module according to claim 1, wherein the reinforcing structure comprises a boss and a groove, both the boss and the groove are disposed around the connection layer, the boss is located between the connection layer and the groove, an orthographic projection of the boss is located within an outer edge of an orthographic projection of the first metal layer in an arrangement direction of the thermally conductive base plate and the ceramic substrate, and the groove is filled with the molding body.

9. The power module according to claim 7 or 8, wherein a surface that is of the boss and that faces the first metal layer is attached to the first metal layer.

10. The power module according to claim 4 or 8, wherein the groove comprises a bottom wall, a first side wall, and a second side wall, the first side wall is connected to an edge of a side that is of the bottom wall and that faces the connection layer, and the second side wall is connected to an edge of a side that is of the bottom wall and that faces away from the connection layer; and
the first side wall is inclined relative to a joint between the first side wall and the bottom wall toward the second side wall; and/or the second side wall is inclined relative to a joint between the second side wall and the bottom wall away from the first side wall.

11. A power converter, comprising a circuit board and the power module according to any one of claims 1 to 10, wherein the power module is disposed on the circuit board.
